# EUROPÄISCHE PATENTSCHRIFT

(11) **EP 2 848 364 B1**
(45) Veröffentlichungstag und Bekanntmachung des Hinweises auf die Patenterteilung: **18.11.2015**
(21) Anmeldenummer: 13184344.3
(22) Anmeldetag: 13.09.2013
(51) Int. Cl.: B23Q 11/14, B23Q 1/00, H02B 1/56

(54) **Bedienpult mit einem Kühlkanal für eine numerisch gesteuerte Werkzeugmaschine**
Control panel with a cooling channel for a numerically controlled machine tool
Pupitre de commande avec un canal de refroidissement pour une machine-outil à commande numérique

(43) Veröffentlichungstag der Anmeldung: 18.03.2015
(73) Patentinhaber: DMG MORI SEIKI AKTIENGESELLSCHAFT, 33689 Bielefeld (DE); DMG MORI SEIKI CO., LTD., Yamatokoriyama-shi, Nara 639-1160 (JP)
(72) Erfinder: Seitz, Reinhold, 87659 Hopferau (DE); Schindler, Dominic, 6923 Lauterach (AT)
(74) Vertreter: MERH-IP Matias Erny Reichl Hoffmann

(56) Entgegenhaltungen:
- DE-U1- 20 204 448
- JP-A- H0 865 825

## Beschreibung

Die vorliegende Erfindung betrifft ein Bedienpult für eine numerisch gesteuerte Werkzeugmaschine mit einer integrierten Kühlvorrichtung.

Im Stand der Technik sind Bedienpulte für numerisch gesteuerte Werkzeugmaschinen (CNC - computergestützte numerische Steuerung) bekannt, die über einen Bildschirm und eine physische Tastatur bzw. eine Vielzahl von Steuerknöpfen verfügen. Die Hardware des Bedienpultes ist häufig extern zu dem Bedienpult angeordnet, z.B. in Form eines Steuercomputers, der mittels einer Kabelverbindungan das Bedienpultangeschlossen ist. Die DE 202 04 448 U offenbart ein Bedienpult gemäß dem Oberbegriff vom Anspruch 1.

Es ist eine Aufgabe der vorliegenden Erfindung ein kompaktes, effizient und intuitiv bedienbares Bedienpult einer numerisch gesteuerten Werkzeugmaschine zu schaffen.

Zur Lösung der Aufgabe wird erfindungsgemäß ein Bedienpult gemäß Anspruch 1 vorgeschlagen. Weitere bevorzugte Weiterentwicklungen der Erfindung sind in den abhängigen Ansprüchen beschrieben.

Gemäß der Erfindung wird ein Bedienpult zur Steuerung einer numerisch gesteuerten Werkzeugmaschine vorgeschlagen, umfassend ein Gehäuse, ein vorderseitig in dem Gehäuse angeordneter Bildschirm, zumindest eine Leiterplatte mit elektrischen Bauteilen, und ein Kühlkanal, durch den ein Fluid leitbar ist. Erfindungsgemäß ist der Kühlkanal zwischen der Leiterplatte und einer rückseitigen Wand des Gehäuses angeordnet ist und innerhalb des Gehäuses zwischen einer unteren Öffnung und einer oberen Öffnung verläuft, und die Öffnungen in der rückseitigen Wand des Gehäuses ausgebildet sind.

Die Bedienung der Werkzeugmaschine wird aufgrund des intuitiveren und weniger komplex bedienbaren Bedienpultes verbessert. Die Bedienbarkeit des Bedienpultes wird zusätzlich durch die kompaktere Bauform des Bedienpultes unterstützt, die insbesondere durch eine kompakte und effiziente Kühlvorrichtung ermöglicht wird. Das erfindungsgemäße Bedienpult weist integrierte Computerhardware zusammen mit einer kompakten und effizienten Kühlungsvorrichtung auf und ist gleichzeitig intuitiver und ergonomischer bedienbar.

Das erfindungsgemäße Bedienpult einer numerisch gesteuerten Werkzeugmaschine weist zumindest ein Gehäuse, zumindest einen Bildschirm und zumindest eine Leiterplatte mit elektrischen Bauteilen auf Ferner wird zumindest eine Kühlvorrichtung umfasst. Die Kühlvorrichtung weist einen Kühlkanal auf, durch den ein Fluid leitbar ist. Der Kühlkanal verläuft zwischen zumindest zwei Öffnungen im Gehäuse innerhalb des Gehäuses.

Der Bildschirm kann bevorzugt ein Flachbildschirm sein, d.h. ein Bildschirm mit geringen Tiefenabmessungen, z.B. im Vergleich zu einem Röhrenbildschirm. Bevorzugt ist der Bildschirm ein LCD-, TFT-, Plasma-, LED- und/oder OLED-Bildschirm.

Die Leiterplatte oder auch Leiterplatine weist bevorzugt ein oder mehrere Speicherelemente, ein oder mehrere Mikroprozessoren bzw. Mikrocontroller und eine Vielzahl Leiterbahnen auf. Besonders bevorzugt bildet die Leiterplatte mit den elektrischen Bauteilen einen Computer, der z.B. zur Steuerung der Funktionen des Bedienpultes, des Bildschirms und/oder weiterer Einrichtungen verwendet werden kann. Bevorzugt ist die Leiterplatte hinter dem Bildschirm in einer zur Bildschirmebene parallelen Ebene angeordnet.

Das Fluid ist in einer bevorzugten Ausführungsform Luft, besonders bevorzugt Umgebungsluft, die von der Umgebung des Bedienpultes in den Kühlkanal hineinfließt und aus diesem zurück in die Umgebung aus dem Kühlkanal herausfließt, insbesondere vorteilhaft durch einen natürlich entstehenden thermischen Kamineffekt, in dem erwärmte Luft in dem Kanal hinaufsteigt und zur oberen Austrittsöffnung hinaus strömt, wodurch in der unteren Austrittsöffnung kühlere Umgebungsluft der Werkstatthalle angesaugt wird. In einer derartigen Ausführung ist es vorteilhaft nicht erforderlich, aktive Kühlelemente vorzusehen, wie z.B. Ventilatoren oder andere rotierende Lüfter.

Der Vorteil des erfindungsgemäßen Bedienpultes ist, dass ein kompaktes, intuitiv bedienbares Bedienpult geschaffen wird, was auch aufgrund der Anordnung und Ausprägung der Kühlvorrichtung erreicht wird. So wird bevorzugt die gesamte Kühlleistung, die insbesondere zum Abführen der vom Bildschirm und den elektronischen Bauteilen der Leiterplatte erzeugten Wärme benötigt wird, mit der kompakten Kühlvorrichtung sichergestellt. Die erfindungsgemäße Kühlvorrichtung benötigt dabei bevorzugt auch keine bewegten Teile oder dgl., um einen Fluidstrom durch den Kühlkanal zu leiten. Vielmehr wird bevorzugt insbesondere aufgrund des Temperaturunterschiedes zwischen der Umgebungslufttemperatur und der Lufttemperatur innerhalb des Kühlkanals, ein Fluid-Strömungssystem durch den Kühlkanal, insbesondere unter Ausnutzung von natürlicher Konvektion, etabliert.

Ferner kann die Leiterplatte im Wesentlichen zwischen dem Bildschirm und dem Kühlkanal innerhalb des Gehäuses angeordnet sein, so dass der Kühlkanal die vom Bildschirm und den elektrischen Bauteilen der Leiterplatte erzeugte Wärme besonders effektiv abführen kann. Bevorzugt kann der Kühlkanal im Wesentlichen parallel zur Leiterplatte und Bildschirmfläche angeordnet sein.

Ferner ist der Bildschirm bevorzugt berührungsempfindlich, d.h. z.B. der Bildschirm kann als sog. Touchscreen ausgebildet sein. Vorzugsweise ist der Bildschirm berührungsempfindlich ausgebildet und dazu eingerichtet, dass Steuerbefehle eines Bedieners zur Steuerung einer mit dem Bedienpult verbindbaren numerisch gesteuerten Werkzeugmaschine mittels Berührung des Bildschirms eingebbar sind.

Der Bildschirm kann derart konfiguriert sein, dass beispielsweise Steuerbefehle zur Steuerung einer mit dem Bedienpult verbindbaren numerisch gesteuerten Werkzeugmaschine mittels Berührung des Bildschirms oder einer Annäherung an den Bildschirm eingebbar sind. Dies erlaubt, dass die Bedienung besonders intuitiv möglich ist, da der Nutzer direkt auf bzw. an dem Bildschirm seine Steuerbefehle eingeben kann, gleichzeitig alle wichtigen Informationen auf dem Bildschirm angezeigt bekommt und keine externe Tastatur oder dgl. benötigt wird.

Ferner kann die Leiterplatte, der Bildschirm und die Kühlungsvorrichtung in einem selben Gehäuse des Bedienpultes angeordnet sind. In einem selben Gehäuse bedeutet, dass ein Gehäuse die Komponenten zusammen aufnimmt. Das Gehäuse kann mehrteilig oder einteilig ausgebildet sein. Die Anordnung der Komponenten in demselben Gehäuse erlaubt, dass das Bedienpult noch kompakter ausgeführt sein kann.

Ferner kann der Bildschirm an einer Gehäusevorderseite angeordnet sein. Die zumindest zwei Öffnungen können an einer Gehäuserückseite angeordnet sein. Eine zumindest erste Öffnung kann im Bereich einer Unterkante des Gehäuses und eine zumindest zweite Öffnung kann im Bereich einer Oberkante des Gehäuses angeordnet sein. Der Kühlkanal kann zwischen der ersten und der zweiten Öffnung angeordnet sein.

"Bereich einer Unterkante" des Gehäuses bedeutet im Wesentlichen ein unterer Abschnitt des Gehäuses und "Bereich einer Oberkante" bedeutet im Wesentlichen ein oberer Abschnitt des Gehäuses, der bevorzugt die Kante des Gehäuses und einen Abschnitt um die Kante herum miteinschließt. Diese Anordnung des Kühlkanaleinlasses bzw. -auslasses unterstützt weiter die Ausprägung einer natürlichen Konvektionsströmung von Umgebungsluft durch den Kühlkanal hindurch, da die Luft innerhalb des Kühlkanals aufgrund der Abwärme des Bildschirms und der elektronischen Bauteile wärmer ist als die Umgebungsluft, wird die Umgebungsluft in den Kühlkanal hineingesogen.

Ferner kann das Bedienpult bzw. das Gehäuse einen Fuß und/oder einen Verbindungsabschnitt aufweisen. Eine Öffnung des Kühlkanals kann auch (oder alternativ) im Bereich des Fußes bzw. Verbindungsabschnittes vorgesehen sein, insbesondere und bevorzugt, wenn der Fuß bzw. der Verbindungsabschnitt unterhalb der Unterkante des Gehäuses angeordnet ist.

Ferner können Rippen an der Leiterplatte und/oder im Bereich der Leiterplatte angeordnet sind, die zumindest teilweise in den Kühlkanal hineinragen können. Die Rippen können ein wärmeleitendes Material aufweisen.

Zumindest teilweise in den Kühlkanal hineinragen kann beispielsweise bedeuten, dass die Rippen bis z.B. einer halben Kühlkanalhöhe in den Kühlkanal hinein stehen. Weiterhin ist es möglich, dass die Rippen bis zu einer Viertel- oder Dreiviertelhöhe der Kühlkanalhöhe in diesen hineinragen. Weiter schließt der Begriff Rippen nicht andere Bauformen wie z.B. nadelförmige, zylindrische und/oder hohl ausgeführte Teile aus. Eine wesentliche technische Funktion ist das Ableiten von Wärme von den elektronischen Bauteilen bzw. der Leiterplatte zu dem Kühlkanal. Die Rippen weisen vorzugsweise ein wärmeleitendes Material auf, wie z.B. Metall, insbesondere Kupfer oder Aluminium.

Ferner kann die Kühlvorrichtung ein aktives Kühlelement umfassen, das das Fluid innerhalb des Kühlkanals in Bewegung versetzen kann, so dass das Fluid von der ersten zu der zweiten Öffnung fließen kann. Das aktive Kühlelement kann beispielsweise ein Ventilator, z.B. vergleichbar einem CPU-Lüfter, sein, der innerhalb des Kühlkanals angeordnet sein kann und den Fluidstrom, der aufgrund natürlicher Konvektion vorhanden ist, weiter verstärkt. Somit kann auch der Wärmeabtransport verbessert werden.

Ferner kann zumindest eine Seitenwand des Kühlkanals von einer Gehäuserückwand gebildet sein. Eine Seitenwand des Kühlkanals, die benachbart zu der Leiterplatte angeordnet sein kann, kann ferner offen ausgebildet sein oder mittels eines Wandelementes gebildet sein.

Seitenwand bezeichnet hier die Wandung, die eine Mantelfläche des Kühlkanals bildet bzw. bedeckt. Der Kühlkanal kann unter anderem auch eine geschlossene Mantelfläche aufweisen, so dass das Fluid zwischen den Öffnungen nur innerhalb des Kühlkanals strömen kann.

Wandelement ist im bevorzugten Fall ein plattenförmiges Element, z.B. aus Metall, das mit dem Gehäuse, insbesondere bevorzugt mit der Gehäuserückwand, verbunden ist und so eine Seitenwand des Kühlkanals bildet bzw. bedeckt.

Eine geschlossene Mantelfläche bedeutet im Wesentlichen, dass lediglich die Öffnungen im Gehäuse, die Ein- und Ausgang zum Kühlkanal bilden, für den Fluidstrom passierbar sind. Mit anderen Worten bedeutet eine geschlossene Mantelfläche somit im Wesentlichen, dass die Seitenflächen bzw. -wände des Kühlkanals den Fluidstrom nicht passieren lassen. Dies hat den Vorteil, dass das Fluid nur innerhalb des Kühlkanals innerhalb des Gehäuses fließt und somit eine hohe Fließgeschwindigkeit mit einhergehendem hohem Wärmeübergangskoeffizienten hat. Der Wärmeabtransport wird dadurch weiter verbessert. Eine zumindest teilweise offene Mantelfläche wiederrum erlaubt, dass Rippen von dem Bereich, in dem die Leiterplatte angeordnet ist, in den Kühlkanal geführt werden können und/oder dass Fluid direkt bis zu der Leiterplatte fließen kann, um dort eine direkte Kühlung der Bauteile zu bewirken.

Die geschlossene Mantelfläche kann z.B. mittels eines Hohlprofils realisiert sein, dass zwischen den Öffnungen innerhalb das Gehäuse angeordnet sein. Weiter können auch Seitenwände beispielsweise mittels einzelner plattenförmiger Elemente, z.B. dem Wandelement oder der Gehäuserückwand, ausgebildet sein.

Ferner kann die Gehäuserückwand eine im Wesentlichen nichtebene Form zumindest im Bereich des Kühlkanals aufweisen. Das Wandelement kann eine im Wesentlichen ebene Form zumindest im Bereich des Kühlkanals aufweisen. So kann der Kühlkanal, insbesondere mit geschlossener Mantelfläche, nur mittels der Gehäusewand und dem Wandelement bildbar sein.

Die Gehäuserückwand kann z.B. im Wesentlichen elliptisch, halbkugelförmig, oder allgemein gebogen bzw. geknickt sein, so dass nur mittels des einen weiteren plattenförmigen Wandelementes die Seitenwände des Kühlkanals bildbar sind.

Dies hat den Vorteil, dass keine weiteren Bauteile oder Wandungen gebildet bzw. vorgesehen werden müssen, was wiederum eine weniger komplexe und kompaktere Bauform der Kühlvorrichtung und damit des Bedienpultes ermöglicht.

Das Wandelement des Kühlkanals kann eine Aufnahmeöffnung aufweisen, so dass die Rippen derart angeordnet sein können, dass die Rippen durch die Aufnahmeöffnung in den Kühlkanal hineinragen können.

Wenn Rippen vorgesehen sind, können diese durch eine oder mehrere Mantelflächen des Kühlkanals hindurchragen. Dazu können z.B. Durchgangslöcher in den Mantelflächen vorgesehen sein, die die Rippen bevorzugt passgenau aufnehmen. Es können auch Dichtungen an den Stellen, an den die Rippen durch die Mantelfläche durchstoßen vorgesehen sein, um einen Austritt von Fluidstrom an den Mantelflächen im Bereich der Rippen zu verhindern.

Ferner kann die Leiterplatte innerhalb eines Vorrichtungsgehäuses angeordnet sein. Das Vorrichtungsgehäuse kann derart zwischen dem Bildschirm und dem Kühlkanal angeordnet sein, dass elektrische Komponenten, die auf der zumindest einen Leiterplatte befestigt sein können, in Richtung einer Wand des Vorrichtungsgehäuses angeordnet sein können, die unmittelbar an den FluidKühlkanal angrenzen kann. Das Vorrichtungsgehäuse ist bevorzugt eine geschlossene oder einseitige offene Box, die die Leiterplatte und die daran angeordneten Bauteile aufnimmt. Insbesondere im Falle, dass der Kühlkanal zwischen den Öffnungen nicht mittels Seitenwänden begrenzt ist, kann eine Wandung des Vorrichtungsgehäuses gleichzeitig als eine Seitenwand zur Begrenzung des Kühlkanals dienen. Die Ausrichtung der elektrischen Bauteile in Richtung des Kühlkanals bringt den Vorteil mit sich, dass Wärmestrahlung hauptsächlich bereits in Richtung der Kühlvorrichtung emittiert wird.

Das Vorrichtungsgehäuse kann bevorzugt aus Metall oder thermisch gut leitendem Material bestehen. Rippen können beispielsweise aus einem Inneren des Vorrichtungsgehäuses heraus in den Kühlkanal ragen. Alternativ oder zusätzlich können die Rippen an einem äußeren Abschnitt des Vorrichtungsgehäuses angeordnet sein und in den Kühlkanal ragen.

Ferner kann die erste Öffnung eine Fluideingangsöffnung ist und die zweite Öffnung eine Fluidaustrittsöffnung sein. Die erste Öffnung kann einen größeren Querschnitt aufweisen als die zweite Öffnung. Die Fläche des Kühlkanalquerschnitts kann sich von der ersten Öffnung zu der zweiten Öffnung hin verringern. Der Vorteil, der sich aus dem größeren Querschnitt der ersten Öffnung ergibt ist, dass das Fluid insbesondere bei entsprechend angepasster Kühlkanalform innerhalb des Kühlkanals beschleunigt werden kann, so dass der Wärmeabtransport weiter verbessert wird.

Ferner kann sich der Kühlkanalquerschnitt von der ersten Öffnung zu der zweiten Öffnung hin verringern, wobei zwischen der ersten und zweiten Öffnung innerhalb des Kühlkanals alternierend Kühlkanalabschnitte mit vergrößertem Kühlkanalquerschnitt und Kühlkanalabschnitte mit verjüngtem Kühlkanalquerschnitt angeordnet sein können. Diese Anordnung von abwechselnd größeren und kleineren Querschnitten entlang der Strömungsrichtung des Fluids bewirkt eine wiederholte Beschleunigung und Verlangsamung der Flussgeschwindigkeit, so dass Turbulenzen innerhalb des Fluidstroms erzeugt werden, die zu einer weiteren Verbesserung des Wärmeabtransports führen.

Ferner kann eine Kühlkanalbreite, quer zu einer Strömungsrichtung des Fluids, und eine Kühlkanallänge, längs der Strömungsrichtung des Fluids, größer sein als eine Höhe des Kühlkanals. Diese Formgebung des Kühlkanals ermöglicht insbesondere, dass der Kühlkanal flach baut, so dass das Bedienpult im Hinblick auf eine gute Bedienbarkeit kompakt ausgelegt werden kann, und gleichzeitig ein großes Volumen von Fluid durch den Kühlkanal transportierbar ist, um einen hohen Wärmeabtransport sicherzustellen.

Die Breite des Kühlkanals kann dabei im Wesentlichen die gesamte Rückfläche des Gehäuses umfassen oder kleiner sein. Bevorzugt wird z.B. eine Breite des Kühlkanals die ca. 1/3 bis 2/3 der Breite der Gehäuserückseite aufweist.

Die Länge des Kühlkanals wird im Wesentlichen durch die Anordnung der Öffnungen im Gehäuse bestimmt und nimmt bevorzugt die Länge von der Unterkante bis zur Oberkante des Gehäuses ein oder weniger.

Ferner kann genau eine Fluideingangsöffnung und genaue eine Fluidaustrittsöffnung des Kühlkanals vorgesehen sind und die beiden Öffnungen einen im Wesentlichen schlitzförmigen Querschnitt aufweisen. Diese Anordnung ermöglicht, dass ein sehr kompakter und gleichzeitig hocheffektiver Kühlkanal bereitstellbar ist.

Der Bildschirm, die Leiterplatte und der Kühlkanal können innerhalb eines selben einstückigen Gehäuseteils des Gehäuses des Bedienpults der Werkzeugmaschine angeordnet sein.

In einer besonders zweckmäßigen Ausführungsform wird zumindest eine Seitenwand des Kühlkanals von der Gehäuserückwand des Gehäuses gebildet und eine weitere Seitenwand des Kühlkanals, die benachbart zu der Leiterplatte angeordnet ist, ist vorzugsweise mittels eines Wandelementes gebildet ist, das an der Gehäuserückwand des Gehäuses befestigt ist. Dies hat den Vorteil, dass der Lüftungskanal in einem Fertigungsschritt durch einsetzen der Wandelements in das Gehäuse und dessen Befestigung z.B. durch eine Schraub- und/oder Klebeverbindung gebildet werden kann. Dies ist insbesondere dann äußerst zweckmäßig, wenn das Wandelement zugleich eine Stützstruktur für die Leiterplatte und den Bildschirm ausbildet, und die Leiterplatte mit dem Bildschirm in der Fertigung in einem ersten Schritt an dem Wandelement befestigt werden, z.B. durch Schraubverbindung und/oder Klebeverbindung, und danach die gesamte Bildschirmeinheit umfassend den Bildschirm, die Leiterplatte und das Wandelement als Einheit in dem Gehäuse eingesetzt und befestigt werden, wobei zugleich der Kanal gebildet wird.

Vorzugsweise weist die Gehäuserückwand des Gehäuses hierbei zumindest im Bereich des Kühlkanals eine im Wesentlichen nichtebene Form, insbesondere eine nach Außen gewölbte bzw. konkave Form, auf und das Wandelement weist zumindest im Bereich des Kühlkanals eine im Wesentlichen ebene Form auf, derart, dass der Kühlkanal durch Befestigung des Wandelements an der Gehäuserückwand bildbar ist. Dies hat den Vorteil, dass der Kanal allein durch Aufsetzen und Befestigen des Wandelements in das Gehäuse gebildet werden kann.

Vorzugsweise weist das Wandelement des Kühlkanals eine oder mehrere Aufnahmeöffnungen auf, durch die Kühlrippen in den Kühlkanal hineinragen.

Vorzugsweise verringert sich die Fläche des Querschnitts des Kühlkanals von der unteren Öffnung zu der oberen Öffnung. Dies verbessert die natürliche Wirkung des thermischen Kamineffekts noch weiter.

Vorzugsweise ist eine horizontale Breite des Kühlkanals größer oder gleich einer horizontale Breite der Leiterplatte, so dass die Leiterplatte bevorzugt durch einen Fluidstrom über dessen gesamte Breite gekühlt werden kann.

Zusammenfassend ermöglicht die Erfindung, dass das erfindungsgemäße Bedienpult für eine numerisch gesteuerte Werkzeugmaschine eine optimale Bedienbarkeit aufweist, die insbesondere aufgrund der Anordnung und Gestaltung der Kühlvorrichtung und des Bildschirms des erfindungsgemäßen Bedienpultes ermöglicht wird.

Die Erfindung wird im Folgenden exemplarisch mit Bezug auf die beigefügten, schematischen Zeichnungen beschrieben. Es zeigen
Fig. 1 eine perspektivische Ansicht des erfindungsgemäßen Bedienpultes,
Fig. 2 einen Querschnitt des erfindungsgemäßen Bedienpultes und
Fig. 3 einen weiteren Querschnitt des erfindungsgemäßen Bedienpultes.

Im Folgenden werden verschiedene Beispiele der vorliegenden Erfindung detailliert unter Bezugnahme auf die Figuren beschrieben. Gleiche bzw. ähnliche Elemente in den Figuren werden hierbei mit gleichen Bezugszeichen bezeichnet. Die vorliegende Erfindung ist jedoch nicht auf die beschriebenen Ausführungsmerkmale begrenzt, sondern umfasst weiterhin Modifikationen von Merkmalen der beschriebenen Beispiele und Kombination von Merkmalen verschiedener Beispiele im Rahmen des Schutzumfangs des unabhängigen Anspruchs.

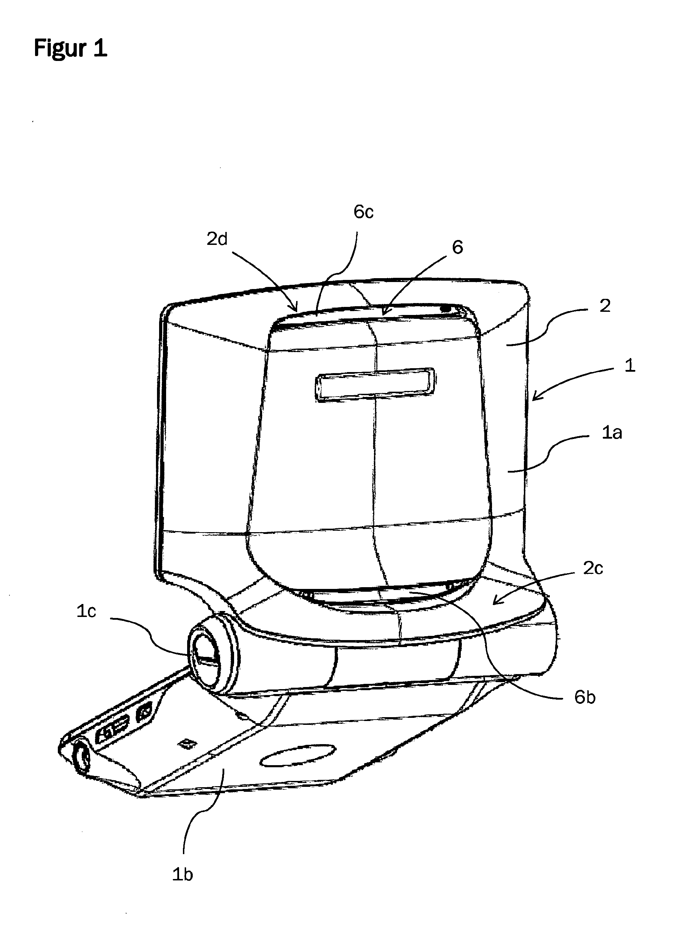

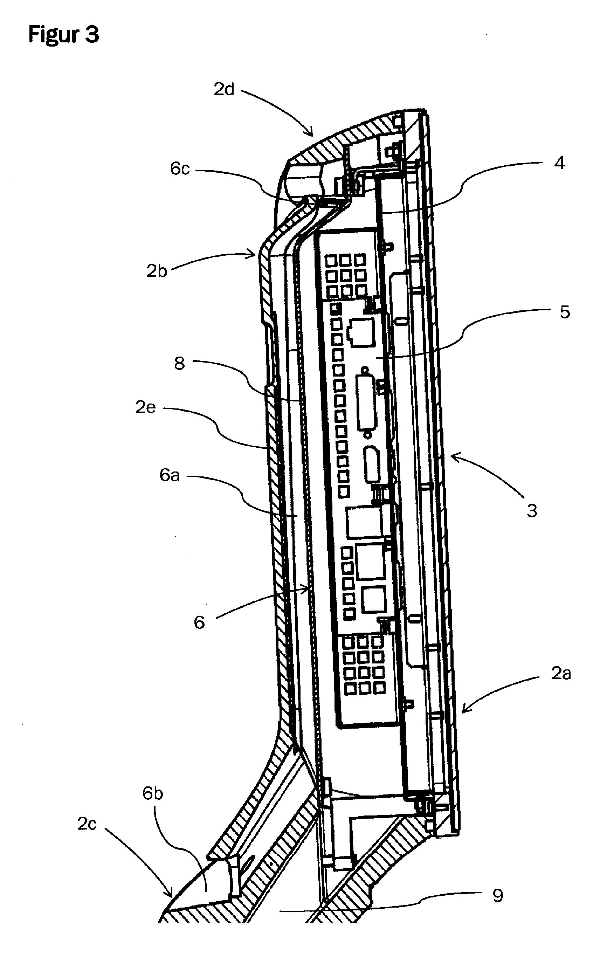

Fig. 1 zeigt das erfindungsgemäße Bedienpult für eine numerisch gesteuerte Werkzeugmaschine in einer perspektivischen Ansicht. Das gezeigte Bedienpult weist ein Oberteil 1a und ein Unterteil 1b auf, die um eine Schwenkachse herum in beliebigem Winkel zueinander verschwenkbar sind. Die Verschwenkachse wird mittels eines Drehlagers 1c bereitgestellt. Beide Teile des Bedienpultes 1, das heißt Oberteil 1a und Unterteil 1b, können jeweils einen Bildschirm 3 und/oder Tastaturelemente zur Bedienung und zur Eingabe von Steuerbefehlen aufweisen. Im Folgenden wird exemplarisch die Ausgestaltung beschrieben, dass das Oberteil 1a einen Bildschirm 3 aufweist, wie auch in Fig. 3 dargestellt. Da ein solcher Bildschirm und die zugehörigen Rechnerkomponenten zur Ansteuerung zum Beispiel des Bildschirms 3 eine große Menge Wärme produzieren und abgeben, ist eine wirksame Abfuhr der produzierten Wärme notwendig. Erfindungsgemäß wird die produzierte Wärme mittels einer Kühlvorrichtung 6, die bevorzugt an einer Gehäuserückseite 2b eines Gehäuses 2 des Bedienpultes 1 vorgesehen ist, abtransportiert.

Fig. 1 zeigt die Gehäuserückseite 2b und die schlitzförmigen Öffnungen 6b und 6c eines Kühlkanals 6a, der Teil der Kühlvorrichtung 6 ist und innerhalb des Gehäuses 2 angeordnet ist. Die perspektivische Darstellung der Rückseite des Bedienpultes 1 gemäß Fig. 1 lässt insbesondere im Hinblick auf das Gehäuse 2 des Oberteils 1a erkennen, dass das Gehäuse 2 mehrteilig ausgeführt ist. Weiterhin ist jedoch auch eine einteilige Ausführung des Gehäuses 2 möglich.

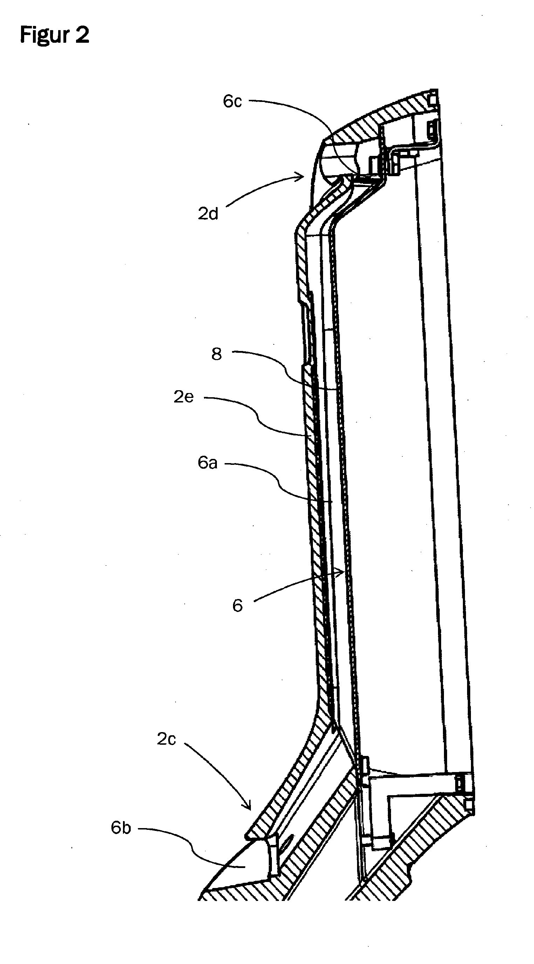

Zum besseren Verständnis der Funktion der Kühlvorrichtung 6 zeigt Fig. 2 einen Querschnitt durch das Oberteil 1a des Bedienpultes 1, wobei auf einer Gehäusevorderseite 2a noch keine Leiterplatte 4 mit elektronischen Bauteilen 5, zum Beispiel CPUs und/oder GPUs, und auch kein Bildschirm 3 eingesetzt ist. Die Fig. 2 zeigt insbesondere den Verlauf des Kühlkanals 6a der Kühlvorrichtung 6, der in der gezeigten Ausgestaltung einen Fluideinlass 6b und einen Fluidauslass 6c in Form der Öffnungen aufweist. Eine Unterkante 2c des Gehäuses 2 des Oberteils 1a weist dabei die Öffnung 6b auf, die bevorzugt ein Fluideinlass ist. Die Oberkante 2d des Gehäuses des Oberteils 1a weist die Öffnung 6c auf, die bevorzugt ein Fluidauslass ist.

Der Fig. 2 lässt sich ferner entnehmen, dass die Gehäuserückwand 2e einen Teil des Kühlkanals 6a nach außen abschließt. Wie die Konturlinien in Fig. 1 zudem veranschaulichen, weist die Gehäuserückwand 2e eine leichte Krümmung in der Querachse zum Gehäuse 2 auf. Diese Formgebung der Gehäuserückwand 2e erlaubt, dass eine Mantelfläche des Kühlkanals 6a mit bevorzugt nur einem weiteren Element, dem Wandelement 8, vollständig verschließbar ist. Die Fig. 2 zeigt das Wandelement, das bevorzugt ein dünnes Blech oder Kunststoffteil ist und einen Aufnahmebereich für die Leiterplatte 4 und die elektronischen Bauteile 5 und den Bildschirm 3 des Gehäuses 2 von dem Kühlkanal 6a abtrennt. Das Wandelement 8 ist jeweils im Bereich einer Unterkante und Oberkante 2c, 2d des Gehäuses 2 mittels zum Beispiel Schraubverbindungen mit dem Gehäuse 2 verbunden. Weiterhin können aber auch Klebeverbindungen oder Steckverbindungen herangezogen werden, um das Wandelement 8 mit dem Gehäuse 2 zu verbinden.

Weiterhin zeigen Fig. 2 und auch Fig. 3, dass der Kühlkanal 6a zwischen den Öffnungen 6b und 6c im Wesentlichen eine Form eines langegezogenen "S" bzw. eines Integralzeichens aufweist, so dass der Kühlkanal 6a bevorzugt der Formgebung des Gehäuses 2 des Oberteils 1a des Bedienpultes 1 folgt. Weiter ist der Kühlkanal 6a in einem Abschnitt des Gehäuses 2, der den Bildschirm 3 und die Leiterplatte 4 aufnimmt, im Wesentlichen parallel zu dem Bildschirm 3 (s. Fig. 3) angeordnet.

Ferner hat die Öffnung 6b bevorzugt einen größeren Querschnitt als die Öffnung 6c, wie es in den Figuren 2 und 3 gezeigt ist, und der Kühlkanalteil, der sich der Öffnung 6b in Strömungsrichtung eines Fluids anschließt, weist ebenfalls einen größeren Querschnitt auf, als der Abschnitt des Kühlkanals 6a, der in Strömungsrichtung vor der Öffnung 6c angeordnet ist, so dass ein Beschleunigungseffekt des Kühlfluids, das bevorzugt Luft ist, generiert wird. Dieser Beschleunigungseffekt kann mittels eines nicht gezeigten aktiven Kühlelements, beispielsweise einem Ventilator, der in dem Kühlkanal 6a angeordnet ist, weiter verstärkt werden, so dass der konvektive Wärmeaustausch bzw. Wärmeabtransport weiter erhöht wird.

Nicht gezeigt ist in den Figuren, dass das Wandelement 8 eine Aussparung aufweisen kann, so dass eine Durchgangsöffnung zwischen dem Kühlkanal 6a und dem Aufnahmebereich des Gehäuses 2, in dem die elektronischen Bauteile 5 und der Bildschirm 3 angeordnet werden, vorhanden ist. Durch diese Aufnahmeöffnung können nicht gezeigte Rippen 7, die mit den elektronischen Bauteilen 5 und/oder der bzw. den Leiterplatten 4 in Verbindung stehen, bis in den Kühlkanal 6a hinein geführt werden. Die Rippen 7, die durch die Aufnahmeöffnung in den Kühlkanal 6a zumindest teilweise hineinragen, verbessern den Wärmeaustausch zwischen den Wärmeerzeugern und dem Fluid, das die erzeugte Wärme abtransportiert, noch weiter.

Schließlich zeigt Fig. 3 den Querschnitt gemäß Fig. 2 zusammen mit den montierten elektronischen Bauteilen 5, die auf einer oder mehreren Leiterplatten 4 angeordnet sind, und einem Bildschirm 3, der an die Gehäusevorderseite 2a des Gehäuses 2 zum Beispiel mittels gezeigter Schraubverbindung verbunden ist. Der Bildschirm 3 ist wie gezeigt ein Flachbildschirm, bevorzugt basierend auf einer LCD-Technik, TFT-Technik, Plasma-Technik oder OLED-Technik. Besonders bevorzugt ist der Bildschirm auch berührungsempfindlich, so dass eine Eingabe von Steuerbefehlen direkt auf dem Bildschirm mittels Annäherung an den Bildschirm oder Berührung des Bildschirms erfolgen kann.

Fig. 3 zeigt weiterhin, dass die Leiterplatte mittels einer Schraubverbindung mit dem Gehäuse 2 verbunden ist. Die elektronischen Bauteile sind derart auf der Leiterplatte 4 angeordnet, dass die elektronischen Bauteile 5 in Richtung der Gehäuserückseite 2b, das heißt in Richtung des Kühlkanals 6a, angeordnet sind. Dies fördert weiterhin eine optimale Abfuhr der von den elektronischen Bauteilen 5 erzeugten Wärme, die aufgrund der Ausrichtung der elektronischen Bauteile 5 größtenteils in Richtung des Kühlkanals 6a abgegeben wird.

Weiterhin ist in Fig. 3 zu erkennen, dass ein Abschnitt des Gehäuses 2 im Bereich der Unterkante 2c einen weiteren Kühlkanal 9 aufweist. Dieser weitere Kühlkanal 9 kann zusätzlich zum Einspeisen von Kühlfluid, zum Beispiel Luft, in das Gehäuse 2 geeignet sein, so dass ein noch weiter verstärkter Kühleffekt ermöglicht wird.

Zusammenfassend ist festzustellen, dass insbesondere aufgrund der sehr kompakten Bauweise der Kühlvorrichtung 6 mit dem Kühlkanal 6a ein kompaktes Bedienpult 1 bereitgestellt wird, das somit auch weniger aufwendig bedienbar ist. Gleichzeitig wird ein optimaler Abtransport der erzeugten Wärme mittels des wenig komplexen Aufbaus des Kühlkanals 6a der Kühlvorrichtung 6 erreicht. Der berührungsempfindliche, flache Bildschirm 3 ermöglicht zudem, dass die Bedienung des Bedienpultes 1 besonders intuitiv ist.

## Patentansprüche

1. Ein Bedienpult (1) zur Steuerung einer numerisch gesteuerten Werkzeugmaschine, umfassend:
- ein Gehäuse (2),
- ein vorderseitig in dem Gehäuse angeordneter Bildschirm (3),
- zumindest eine Leiterplatte (4) mit elektrischen Bauteilen (5), **dadurch gekennzeichnet daß** das Bedienpult einen Kühlkanal (6a), durch den ein Fluid leitbar ist, aufweist,
wobei der Kühlkanal (6a) zwischen der Leiterplatte (4) und einer rückseitigen Wand (2e) des Gehäuses (2) angeordnet ist und innerhalb des Gehäuses (2) zwischen einer unteren Öffnung (6b) und einer oberen Öffnung (6c) verläuft, und die Öffnungen (6b, 6c) in der rückseitigen Wand (2e) des Gehäuses (2) ausgebildet sind.

2. Das Bedienpult nach Anspruch 1, **gekennzeichnet dadurch, dass**
die Leiterplatte (4) zwischen dem Bildschirm (3) und dem Kühlkanal (6a) innerhalb des Gehäuses (2) angeordnet ist.

3. Das Bedienpult nach einem der voranstehenden Ansprüche, **gekennzeichnet dadurch, dass**
der Bildschirm (3), die Leiterplatte (4) und der Kühlkanal (6a) innerhalb eines selben einstückigen Gehäuseteils des Gehäuses (2) des Bedienpults der Werkzeugmaschine angeordnet sind.

4. Das Bedienpult nach einem der voranstehenden Ansprüche, **gekennzeichnet dadurch, dass**
der Bildschirm (3) an einem Gehäusevorderseitenabschnitt (2a) des Gehäuses (2) angeordnet ist und die zwei Öffnungen (6b, 6c) an einem Gehäuserückseitenabschnitt (2b) des Gehäuses (2) angeordnet sind, wobei
die untere Öffnung (6b) im Bereich einer Unterkante (2c) des Gehäuses (2) und die obere Öffnung (6c) im Bereich einer Oberkante (2d) des Gehäuses (2) angeordnet sind.

5. Das Bedienpult nach einem der voranstehenden Ansprüche, **gekennzeichnet dadurch, dass**
Kühlrippen (7) an der Leiterplatte (4) angeordnet sind, die zumindest teilweise in den Kühlkanal (6a) hineinragen, wobei
die Kühlrippen (7) ein wärmeleitendes Material aufweisen.

6. Das Bedienpult nach einem der voranstehenden Ansprüche, **gekennzeichnet dadurch, dass**
zumindest eine Seitenwand des Kühlkanals (6a) von der Gehäuserückwand (2e) des Gehäuses (2) gebildet wird und eine weitere Seitenwand des Kühlkanals (6a), die benachbart zu der Leiterplatte (4) angeordnet ist, mittels eines Wandelementes (8) gebildet ist, das an der Gehäuserückwand (2e) des Gehäuses (2) befestigt ist.

7. Das Bedienpult nach Anspruch 6, **gekennzeichnet dadurch, dass**
die Gehäuserückwand (2e) des Gehäuses (2) zumindest im Bereich des Kühlkanals (6a) eine im Wesentlichen nichtebene Form aufweist und das Wandelement (8) zumindest im Bereich des Kühlkanals (6a) eine im Wesentlichen ebene Form aufweist, derart, dass der Kühlkanal (6a) durch Befestigung des Wandelements (8) an der Gehäuserückwand (2e) bildbar ist.

8. Das Bedienpult nach Anspruch 5 und einem der Ansprüche 6 oder 7, **gekennzeichnet dadurch, dass**
das Wandelement (8) des Kühlkanals (6a) eine oder mehrere Aufnahmeöffnungen aufweist, durch die Kühlrippen (7) in den Kühlkanal (6a) hineinragen.

9. Das Bedienpult nach einem der voranstehenden Ansprüche, **gekennzeichnet dadurch, dass**
die untere Öffnung (6b) eine Fluideingangsöffnung ist und die obere Öffnung (6c) eine Fluidaustrittsöffnung ist,
wobei die untere Öffnung (6b) eine größere Querschnittfläche als die obere Öffnung (6c) aufweist.

10. Das Bedienpult nach Anspruch 9, **gekennzeichnet dadurch, dass**
sich die Fläche des Querschnitts des Kühlkanals (6a) von der unteren Öffnung (6b) zu der oberen Öffnung (6c) verringert.

11. Das Bedienpult nach einem der voranstehenden Ansprüche, **gekennzeichnet dadurch, dass**
eine horizontale Breite des Kühlkanals (6a) größer oder gleich einer horizontale Breite der Leiterplatte (4) ist.

12. Das Bedienpult nach einem der voranstehenden Ansprüche, **gekennzeichnet dadurch, dass**
der Bildschirm (3) berührungsempfindlich ausgebildet ist und dazu eingerichtet ist, dass Steuerbefehle eines Bedieners zur Steuerung einer mit dem Bedienpult (1) verbindbaren numerisch gesteuerten Werkzeugmaschine mittels Berührung des Bildschirms (3) eingebbar sind.

## Claims

1. A control panel (1) for controlling a numerically controlled machine tool, comprising:
- a housing (2),
- a screen (3) arranged on a front portion of said housing (2),
- at least one circuit board (4) including electric components (5)
**characterized in that** said control panel comprises a cooling channel (6a) through which a fluid can be led,
wherein said cooling channel (6a) is arranged between said circuit board (4) and a rear wall (2e) of said housing (2), and extends within said housing (2) between a lower opening (6b) and an upper opening (6c), said openings (6b, 6c) being formed in said rear wall (2e) of said housing (2).

2. The control panel according to claim 1, **characterized in that**
said circuit board (4) is arranged between said screen (3) and said cooling channel (6a) within said housing (2).

3. The control panel according to one of the preceding claims, **characterized in that**
said screen (3), said circuit board (4) and said cooling channel (6a) are arranged within the same one-piece housing portion of said housing (2) of said control panel of said machine tool.

4. The control panel according to one of the preceding claims, **characterized in that**
said screen (3) is arranged on a housing front side portion (2a) of said housing (2) and said upper opening (6c) is arranged in the region of the upper edge (2d) of said housing (2).

5. The control panel according to one of the preceding claims, **characterized in that**
cooling ribs (7) are arranged on said circuit board (4) protruding at least partially into said cooling channel (6a), wherein
said cooling ribs (7) comprise a heat conducting material.

6. The control panel according to one of the preceding claims, **characterized in that**
at least one sidewall of said cooling channel (6a) is formed by said housing rear wall (2e) of said housing (2), and a further sidewall of said cooling channel (6a) neighbouring said circuit board (4) is formed by means of wall member (8) attached to said housing rear wall (2e) of said housing (2).

7. The control panel according to claim 6, **characterized in that**
said housing rear wall (2e) of said housing (2) has a substantially non-planar shape at least in the region of said cooling channel (6a) and said wall member (8) has a substantially planar shape at least in the region of said cooling channel (6a), such that said cooling channel (6a) can be formed by attaching said wall member (8) to said housing rear wall (2e).

8. The control panel according to claim 5 and one of the claims of 6 or 7, **characterized in that**
said wall member (8) of said cooling channel (6a) comprises one or more accommodation openings through which said cooling ribs (7) protrude into said cooling channel (6a).

9. The control panel according to one of the preceding claims, **characterized in that**
said lower opening (6b) is a fluid inlet opening and said upper opening (6c) is a fluid outlet opening,
wherein said lower opening (6b) has a larger cross-sectional area than said upper opening (6c).

10. The control panel according to claim 9, **characterized in that**
the cross-sectional area of said cooling channel (6) reduces from said lower opening (6b) to said upper opening (6c).

11. The control panel according to one of the preceding claims, **characterized in that**
a horizontal width of said cooling channel (6a) is equal or larger than a horizontal width of said circuit board (4).

12. The control panel according to one of the preceding claims, **characterized in that**
said screen (3) is designed as a touch screen and is arranged such that control commands of an operator for controlling a numerically controlled machine tool connectable to said control panel (1) can be input by touching said screen (3).

## Revendications

1. Pupitre de commande (1) pour commander une machine-outil à commande numérique, comprenant :
- un boîtier (2),
- un écran d'affichage (3) agencé du côté avant dans le boîtier,
- au moins une carte à circuits imprimés (4) dotée de composants électriques (5),
**caractérisé en ce que**
le pupitre de commande comprend un canal de refroidissement (6a) susceptible d'être traversé par un fluide,
le canal de refroidissement (6a) étant agencé entre la carte à circuits imprimés (4) et une paroi (2e) côté arrière du boîtier (2) et s'étendant à l'intérieur du boîtier (2) entre une ouverture inférieure (6b) et une ouverture supérieure (6c), les ouvertures (6b, 6c) étant ménagées dans la paroi arrière (2e) du boîtier (2).

2. Pupitre de commande selon la revendication 1,
**caractérisé en ce que**
la carte à circuits imprimés (4) est agencée entre l'écran d'affichage (3) et le canal de refroidissement (6a) à l'intérieur du boîtier (2).

3. Pupitre de commande selon l'une des revendications précédentes,
**caractérisé en ce que**
l'écran d'affichage (3), la carte à circuits imprimés (4) et le canal de refroidissement (6a) sont agencés à l'intérieur d'une seule et même partie monobloc du boîtier (2) du pupitre de commande de la machine-outil.

4. Pupitre de commande selon l'une des revendications précédentes,
**caractérisé en ce que**
l'écran d'affichage (3) est agencé sur une portion (2a) côté avant du boîtier (2) et les deux ouvertures (6b, 6c) sont ménagées sur une portion (2b) côté arrière du boîtier (2),
l'ouverture inférieure (6b) étant ménagée au niveau d'un bord inférieur (2c) du boîtier (2) et l'ouverture supérieure (6c) étant ménagée au niveau d'un bord supérieur (2d) du boîtier (2).

5. Pupitre de commande selon l'une des revendications précédentes,
**caractérisé en ce que**
des ailettes de refroidissement (7) sont agencées sur la carte à circuits imprimés (4), qui pénètrent au moins partiellement dans le canal de refroidissement (6a),
les ailettes de refroidissement (7) présentant un matériau conducteur de chaleur.

6. Pupitre de commande selon l'une des revendications précédentes,
**caractérisé en ce que**
une paroi latérale au moins du canal de refroidissement (6a) est formée par la paroi arrière (2e) du boîtier (2), et au moins une autre paroi latérale du canal de refroidissement (6a) agencée au voisinage de la carte à circuits imprimés (4) est formée au moyen d'un élément de paroi (8) qui est fixé sur la paroi arrière (2e) du boîtier (2).

7. Pupitre de commande selon la revendication 6,
**caractérisé en ce que**
la paroi arrière (2e) du boîtier (2) présente une forme sensiblement non plane au moins au niveau du canal de refroidissement (6a), et l'élément de paroi (8) présente une forme sensiblement plane au moins au niveau du canal de refroidissement (6a), de telle sorte que le canal de refroidissement (6a) est susceptible d'être formé par fixation de l'élément de paroi (8) sur la paroi arrière (2e) du boîtier.

8. Pupitre de commande selon la revendication 5 et selon l'une des revendications 6 ou 7,
**caractérisé en ce que**
l'élément de paroi (8) du canal de refroidissement (6a) présente une ou plusieurs ouvertures de réception à travers lesquelles les ailettes de refroidissement (7) pénètrent dans le canal de refroidissement (6a).

9. Pupitre de commande selon l'une des revendications précédentes,
**caractérisé en ce que**
l'ouverture inférieure (6b) est une ouverture d'entrée de fluide et l'ouverture supérieure (6c) est une ouverture de sortie de fluide,
l'ouverture inférieure (6b) présentant une surface en section transversale plus grande que celle de l'ouverture supérieure (6c).

10. Pupitre de commande selon la revendication 9,
**caractérisé en ce que**
la surface en section transversale du canal de refroidissement (6a) décroît depuis l'ouverture inférieure (6b) vers l'ouverture supérieure (6c).

11. Pupitre de commande selon l'une des revendications précédentes,
**caractérisé en ce que**
une largeur horizontale du canal de refroidissement (6a) est supérieure ou égale à une largeur horizontale de la carte à circuits imprimés (4).

12. Pupitre de commande selon l'une des revendications précédentes,
**caractérisé en ce que**
l'écran d'affichage (3) est du type écran tactile et est conçu de manière à permettre à un utilisateur d'entrer des instructions de commande pour commander une machine-outil à commande numérique, susceptible d'être reliée au pupitre de commande (1), en touchant l'écran d'affichage (3).
